# EUROPÄISCHE PATENTSCHRIFT

(11) **EP 4 379 286 B1**
(45) Veröffentlichungstag und Bekanntmachung des Hinweises auf die Patenterteilung: **11.03.2026**
(21) Anmeldenummer: 23197962.6
(22) Anmeldetag: 18.09.2023
(51) Int. Cl.: F24H 15/144, G01R 22/00, G05B 1/00, G01R 22/06, F24H 15/375, F24F 11/46, F24F 11/50, F24F 11/62, F24F 130/10, G01R 21/133, F24F 140/60

(54) **IDENTIFIZIERUNG EINER KONFIGURATION EINER WÄRMEPUMPE BASIEREND AUF EINEM GESAMTSTROMVERBRAUCH**
IDENTIFYING A CONFIGURATION OF A HEAT PUMP BASED ON TOTAL POWER CONSUMPTION
IDENTIFICATION D'UNE CONFIGURATION D'UNE POMPE À CHALEUR SUR LA BASE D'UNE CONSOMMATION TOTALE D'ÉNERGIE

(30) Priorität: 29.11.2022 DE 102022131614
(43) Veröffentlichungstag der Anmeldung: 05.06.2024
(73) Patentinhaber: E.ON SE, 45131 Essen (DE)
(72) Erfinder: Dr. Grote, Markus, 40822 Mettmann (DE); Ritzmann, Mark, 40670 Meerbusch (DE)
(74) Vertreter: Gunzelmann, Rainer

(56) Entgegenhaltungen:
- DE-A1- 102011 052 467
- DE-A1- 102017 112 505
- DE-A1- 102020 117 900
- US-B2- 11 092 953

## Beschreibung

### TECHNISCHES GEBIET

Die vorliegende Offenbarung betrifft allgemein das technische Gebiet der Wärmepumpen. Insbesondere betrifft die vorliegende Offenbarung ein Verfahren zum Identifizieren einer Konfiguration einer Wärmepumpe, ein Computerprogrammprodukt und ein System.

### HINTERGRUND

In letzter Zeit kommen in Wohnhäusern und anderen Gebäuden vermehrt Wärmepumpen zum Einsatz. Diese nutzen elektrische Energie zur Erwärmung eines Fluids, wobei das erwärmte Fluid dem Gebäude zugeführt wird. Bei dem erwärmten Fluid kann es sich um Luft handeln, die in einzelne Räume eingeblasen wird, oder um Wasser, welches der Warmwasserversorgung und/oder Heizung des Gebäudes dient.

Wärmepumpen verbrauchen gegenüber anderen Heizungstypen, wie z.B. Gas- oder Ölheizungen, meist weniger Energie. Allerdings hängt der Energieverbrauch einer Wärmepumpe, und damit auch deren CO₂-Bilanz, stark von einer Einstellung bzw. Konfiguration der Wärmepumpe ab. Die meisten Wärmepumpen ermöglichen zur Änderung einer aktuellen Konfiguration der Wärmepumpe die Anpassung eines Werts eines Konfigurationsparameters, beispielsweise eine Anpassung einer durch die Wärmepumpe bereitzustellenden Raumtemperatur.

Üblicherweise werden Wärmepumpen bei der erstmaligen Inbetriebnahme mit einer Standardkonfiguration in Betrieb genommen, welche den Konfigurationsparameter auf einen Standardwert festlegt. Zwar kann so in den meisten Fällen eine zufriedenstellende Temperatur des erwärmten Fluids sichergestellt werden, allerdings kann es vorkommen, dass die Standardkonfiguration bezüglich des Energieverbrauchs der Wärmepumpe Optimierungspotenzial aufweist. Aus diesem Grund ist aktuell vorgesehen, dass Benutzer von Wärmepumpen in deren erstem Betriebsjahr manuell Buch führen über Kennzahlen der jeweiligen Wärmepumpe. Nach dem Ende des ersten Betriebsjahrs führt ein Wartungsbetrieb eine Prüfung der notierten Kennzahlen durch. Auf Grundlage von Erfahrungen des Wartungsbetriebs kann dann die Wärmepumpe final auf eine Konfiguration eingestellt werden.

Die DE 10 2020 117900 A1 beschreibt ein Verfahren zum Betrieb eines Stromverbrauchsmesssystems, das den Stromverbrauch an einem überwachten Standort messen und den Status des Stromverbrauchers identifizieren kann. Das Verfahren umfasst ein Messen von Stromverbrauchswerten über die Zeit durch einen Sensor, ein Bereitstellen eines Wertemusters für ein Cloud-basiertes Datenverarbeitungssystem, ein Identifizieren des Status des Stromverbrauchers und ein Zählen der Betriebszeit des Stromverbrauchers.

Die US 11 092 953 B2 beschreibt ein Verfahren und ein System zur Erkennung von Fehlfunktionen und Ineffizienzen von Heating Ventilation and Air Conditioning (HVAC) Systemen über Smart-Meter-Daten. Es wird ferner ein Verfahren zur Bestimmung von Bedingungen für Fehlfunktionen oder Ineffizienzen von HVAC-Systemen beschrieben.

Die DE 10 2011 052467 A1 beschreibt ein gebäudetechnisches Steuerungssystem, das den Komfort der Nutzer erhöht und Energie spart, indem es die Steuerung von Heiz-, Kühl-, Beleuchtungs- und Haushaltsgeräten auf den aktuellen Zustand und das Verhalten der Gebäudenutzer abstimmt. Es nutzt diverse Erfassungstechnologien, darunter Geodaten, Gerätedaten, Funkfrequenzüberwachung und Stromverbrauch, um präzise Nutzerzustände zu bestimmen und darauf basierend die Steuerung der Systeme anzupassen. Historische Nutzerdaten werden analysiert, um typische Verhaltensmuster zu erkennen und die Steuerung weiter zu optimieren.

Die DE 10 2017 112505 A1 beschreibt ein Verfahren zum Betreiben eines thermischen Verbrauchssystems, das es ermöglicht, den individuellen Energieverbrauch einzelner thermischer Verbraucher innerhalb eines Systems zu bestimmen. Es umfasst das Erfassen eines Gesamt-Verbrauchsprofils für alle Verbraucher und die Bestimmung individueller Verbrauchsprofile basierend auf gespeicherten Profildatensätzen.

### KURZER ABRISS

Der vorliegenden Offenbarung liegt die Aufgabe zugrunde, ein Verfahren bereitzustellen, das es ermöglicht, rasch und kostengünstig eine Konfiguration einer Wärmepumpe zu identifizieren.

Gemäß einem ersten Aspekt wird ein Verfahren gemäß Anspruch 1 zum Identifizieren einer Konfiguration einer Wärmepumpe bereitgestellt. Das Verfahren umfasst ein Erhalten einer Zeitreihe von Messwerten eines Gesamtstromverbrauchs einer Betriebsstätte, wobei zumindest einer der Messwerte einen Gesamtstromverbrauch der Betriebsstätte angibt, der einen Stromverbrauch einer Wärmepumpe umfasst. Das Verfahren umfasst ferner ein Identifizieren einer Konfiguration der Wärmepumpe auf Grundlage der Zeitreihe von Messwerten.

Hierzu ist es nicht notwendig, dass ein Benutzer der Wärmepumpe einzelne Kennzahlen der Wärmepumpe notiert. Auch ist es nicht notwendig, den Stromverbrauch der Wärmepumpe separat von weiteren elektrischen Verbrauchern der Betriebsstätte zu zählen. Stattdessen wird der Gesamtstromverbrauch der Betriebsstätte genutzt, um die Konfiguration der Wärmepumpe zu identifizieren.

Die Zeitabstände zwischen den Messwerten aus der Zeitreihe von Messwerten sind beispielsweise gleich groß. Der Gesamtstromverbrauch kann periodisch gemessen werden um die Zeitreihe von Messwerten zu generieren. Es ist jedoch ebenso denkbar, dass die Zeitabstände zwischen einzelnen Messwerten aus der Zeitreihe von Messwerten unterschiedlich groß sind.

Die Wärmepumpe dient insbesondere der Versorgung der Betriebsstätte mit erwärmtem Fluid, z.B. erwärmter Luft und/oder erwärmtem Wasser. Die Betriebsstätte kann ein Gebäude umfassen oder sein, beispielsweise ein Wohngebäude, ein Bürogebäude oder ein Fabrikgebäude. Die Wärmepumpe kann in oder neben dem Gebäude angeordnet sein. Vorzugsweise ist die Wärmepumpe nicht weiter als wenige Meter (z.B. 5m, 10m oder 50m) von dem Gebäude entfernt. Auch wenn die Wärmepumpe räumlich gesehen nicht in dem Gebäude angeordnet ist, kann man sagen, dass die Betriebsstätte die Wärmepumpe umfasst, insbesondere, da die Wärmepumpe über die Betriebsstätte mit Strom versorgt wird. Die Betriebsstätte umfasst beispielsweise mindestens einen elektrischen Verbraucher, der über die Betriebsstätte mit Strom versorgt wird und daher zumindest in seinem aktivierten bzw. eingeschalteten Zustand zum Gesamtstromverbrauch der Betriebsstätte beiträgt. Der Gesamtstromverbrauch der Betriebsstätte kann sich demnach aus dem Stromverbrauch des mindestens einen elektrischen Verbrauchers und der Wärmepumpe zusammensetzen, wobei die jeweiligen Stromverbrauchsanteile des mindestens einen elektrischen Verbrauchers und der Wärmepumpe zeitlich variabel sind.

Der Gesamtstromverbrauch kann von einer Stromzählervorrichtung gemessen werden, insbesondere in Abhängigkeit von der Zeit. Die Stromzählervorrichtung kann ein standardisierter, insbesondere digitaler, Stromzähler oder Teil eines intelligenten Stromzählers (engl. "Smart Meter") sein. Die Stromzählervorrichtung oder eine mit der Stromzählervorrichtung gekoppelte Messwertbereitstellungseinheit kann basierend auf den Messungen der Stromzählervorrichtung die Messwerte und/oder die Zeitreihe von Messwerten generieren.

Das Verfahren kann ferner ein Ermitteln des Stromverbrauchs der Wärmepumpe für den zumindest einen Messwert umfassen. Der Stromverbrauch der Wärmepumpe kann eine Vielzahl von Stromverbrauchswerten der Wärmepumpe umfassen, die unterschiedlichen Zeiten zugeordnet sind. Der Stromverbrauch oder der Stromverbrauchswert kann dem Stromverbrauchsanteil der Wärmepumpe an dem Gesamtstromverbrauch entsprechen, welcher Gesamtstromverbrauch von dem zumindest einen Messwert beschrieben wird bzw. dem zumindest einen Messwert zugeordnet ist. Die Konfiguration der Wärmepumpe kann auf Grundlage des ermittelten Stromverbrauchs identifiziert werden.

Vorzugsweise wird der Stromverbrauch der Wärmepumpe durch Disaggregation zumindest eines Teils der Zeitreihe von Messwerten ermittelt. Hierbei umfasst der Teil der Zeitreihe insbesondere den zumindest einen Messwert. Der Teil der Zeitreihe kann eine Vielzahl an Messwerten umfassen. Es ist auch möglich, dass der Stromverbrauch der Wärmepumpe durch Disaggregation der gesamten Zeitreihe von Messwerten ermittelt wird.

Die Disaggregation kann beispielsweise der Wärmepumpe und/oder dem mindestens einen elektrischen Verbraucher jeweilige Stromverbrauchsanteile am Gesamtstromverbrauch zuordnen, insbesondere für verschiedene oder alle Zeitpunkte der Zeitreihe. Die Disaggregation kann beispielsweise die jeweiligen Stromverbrauchsanteile unterschiedlichen Typen von elektrischen Verbrauchern wie z.B. Leuchtmitteln, Kühlschränken, Elektroöfen, Klimaanlagen, Waschmaschinen oder dergleichen zuordnen. Die Disaggregation kann eine Mustererkennung umfassen, wobei vorbekannte Stromverbrauchsmuster des mindestens einen Verbrauchers und/oder der Wärmepumpe auf Grundlage der Zeitreihe von Messwerten detektiert werden. Die Disaggregation kann einen Vergleich vorbekannter Stromverbrauchsmuster elektrischer Verbraucher und/oder Wärmepumpen(- konfigurationen) mit der Zeitreihe von Messwerten umfassen. Die Disaggregation kann einen Vergleich vorbekannter (z.B. minimaler, maximaler, durchschnittlicher, Einschalt- oder Ausschalt-) Stromverbrauchswerte elektrischer Verbraucher und/oder Wärmepumpen(-konfigurationen) mit der Zeitreihe von Messwerten umfassen. Die Disaggregation kann mittels sogenanntem "Nonintrusive Appliance Load Monitoring" (NALM) durchgeführt werden. Weitere Ansätze zur Durchführung der Disaggregation sind ebenso denkbar, solange diese basierend auf der Zeitreihe von Messwerten den Stromverbrauch der Wärmepumpe liefern.

Das Verfahren kann ferner ein Vergleichen der identifizierten Konfiguration der Wärmepumpe mit einer Referenzkonfiguration umfassen. Das Verfahren kann ferner ein Bestimmen umfassen, dass und/oder wie die identifizierte Konfiguration (z.B. ein Wert zumindest eines Konfigurationsparameters gemäß der identifizierten Konfiguration) der Wärmepumpe optimiert werden sollte, wenn die identifizierte Konfiguration (z.B. der Wert des zumindest einen Konfigurationsparameters gemäß der identifizierten Konfiguration) von der Referenzkonfiguration (z.B. einem Wert des zumindest einen Konfigurationsparameters gemäß der Referenzkonfiguration) mehr als eine vordefinierte Toleranz abweicht. Beispielsweise kann bestimmt werden, dass ein Wert zumindest eines Konfigurationsparameters der Wärmepumpe von einem Wert gemäß der identifizierten Konfiguration auf einen Wert gemäß der Referenzkonfiguration geändert werden sollte, insbesondere, wenn diese Werte eine Differenz aufweisen, die größer ist als eine von der vordefinierten Toleranz definierte Differenz.

Beispielsweise umfasst das Verfahren ein Ermitteln eines (z.B. durchschnittlichen, maximalen, prognostizierten oder durch eine vorbestimmte Formel definierten) Energieverbrauchs der Wärmepumpe auf Grundlage der identifizierten Konfiguration. Das Verfahren kann ein Vergleichen des ermittelten Energieverbrauchs mit einem entsprechend auf Grundlage der Referenzkonfiguration ermittelten (z.B. durchschnittlichen, maximalen, prognostizierten oder durch die vorbestimmte Formel definierten) Energieverbrauch umfassen. Wenn der der identifizierten Konfiguration zugeordnete Energieverbrauch mehr als ein von der vordefinierten Toleranz definierter Toleranzwert höher liegt als der der Referenzkonfiguration zugeordnete Energieverbrauch, dann kann bestimmt werden, dass und/oder wie die identifizierte Konfiguration der Wärmepumpe optimiert werden sollte. Beispielsweise kann hierbei bestimmt werden, dass ein Wert zumindest eines Konfigurationsparameters der Wärmepumpe von einem Wert gemäß der identifizierten Konfiguration auf einen Wert gemäß der Referenzkonfiguration geändert werden sollte.

Die Referenzkonfiguration kann auf einem vordefinierten Stromverbrauchsprofil der Wärmepumpe, auf Wetterdaten und/oder auf einem Verhaltensmuster eines oder mehrerer Bewohner der Betriebsstätte basieren. Das Verfahren kann ein Erhalten der Referenzkonfiguration (z.B. aus einem Speichermedium, auf Grundlage einer Benutzereingabe oder von einer separaten Vorrichtung) umfassen. Das Verfahren kann ein Generieren der Referenzkonfiguration auf Grundlage des Stromverbrauchsprofils, der Wetterdaten und/oder des Verhaltensmusters umfassen.

Es ist auch möglich, die Referenzkonfiguration aus einer Vielzahl von Referenzkonfigurationen auszuwählen, insbesondere basierend auf dem Stromverbrauchsprofil der Wärmepumpe, Wetterdaten und/oder einem Verhaltensmuster. Beispielsweise kann eine am besten zu der Zeitreihe der Messwerte, insbesondere zu dem Stromverbrauchsprofil der Wärmepumpe, den Wetterdaten und/oder dem Verhaltensmuster, passende Referenzkonfiguration ausgewählt werden. Hierbei kann jede der Referenzkonfigurationen für ein vordefiniertes Stromverbrauchsprofil der Wärmepumpe, für vordefinierte Wetterdaten und/oder ein vordefiniertes Verhaltensmuster optimiert sein. Die so ausgewählte Referenzkonfiguration kann anschließend mit der identifizierten Konfiguration der Wärmepumpe verglichen werden.

Die Wetterdaten können mindestens einen Wetterparameter (z.B. eine Lufttemperatur, eine Luftfeuchte, eine Helligkeit, eine Anzahl von Sonnenstunden, eine Regenmenge, eine Schneemenge etc.) umfassen, der insbesondere der Betriebsstätte bzw. der geographischen Umgebung der Betriebsstätte zugeordnet ist. Der Wetterparameter kann auf einer lokalen Messung im Umfeld der Betriebsstätte oder auf einem Wettermodell basieren.

Beispielsweise umfassen die Wetterdaten eine Wetterhistorie und/oder eine Wetterprognose. Ein Wert zumindest eines Konfigurationsparameters gemäß der Referenzkonfiguration kann auf der Wetterhistorie und/oder der Wetterprognose basieren. Dieser Wert kann entweder (z.B. aus dem Speichermedium, auf Grundlage einer Benutzereingabe oder von der separaten Vorrichtung) erhalten werden oder als Teil des Verfahrens auf Grundlage der Wetterhistorie und/oder der Wetterprognose bestimmt werden. Beispielsweise umfasst die Wetterhistorie für einen oder mehrere Zeitpunkte der Zeitreihe jeweils einen Wert des mindestens einen Wetterparameters. Die Wetterprognose kann für in der Zukunft liegende Zeitpunkte jeweils einen Wert des mindestens einen Wetterparameters umfassen.

Es kann vorgesehen sein, dass zusätzlich zu der Zeitreihe von Messungen die Wetterhistorie erhalten wird. Das Identifizieren der Konfiguration der Wärmepumpe kann dann ferner auf der erhaltenen Wetterhistorie basieren. Auch kann vorgesehen sein, das Referenzmodell basierend auf der Wetterhistorie auszuwählen. Alternativ oder zusätzlich dazu kann die Referenzkonfiguration basierend auf der Wetterhistorie generiert werden.

Ein Wert zumindest eines Konfigurationsparameters gemäß der Referenzkonfiguration kann auf dem Verhaltensmuster basieren. Das Verhaltensmuster kann eine Verhaltenshistorie und/oder eine Verhaltensprognose umfassen. Das Verhaltensmuster kann auf einem jeweiligen Stromverbrauch der Wärmepumpe und des mindestens einen elektrischen Verbrauchers der Betriebsstätte basieren. Hierbei ist der jeweilige Stromverbrauch durch Disaggregation zumindest eines Teils der Zeitreihe von Messwerten ermittelt. Das Verfahren kann diese Disaggregation umfassen, um dem mindestens einen elektrischen Verbraucher und der Wärmepumpe jeweilige Stromverbrauchsanteile zuzuordnen. Basierend auf dem zeitlichen Verlauf der Stromverbrauchsanteile, und optional auch basierend auf dem bzw. den Typ(en) von elektrischen Verbrauchern, die den jeweiligen Stromverbrauchsanteilen zugeordnet sind, kann das Verhaltensmuster des oder der Bewohner der Betriebsstätte ermittelt werden.

Das Verfahren kann ferner ein Erzeugen erster Informationen umfassen, wenn bestimmt wird, dass die identifizierte Konfiguration der Wärmepumpe optimiert werden sollte. Beispielsweise indizieren die ersten Informationen, dass die identifizierte Konfiguration der Wärmepumpe optimiert werden sollte.

Das Verfahren kann ferner ein Erzeugen zweiter Informationen umfassen, wenn bestimmt wird, wie die identifizierte Konfiguration der Wärmepumpe optimiert werden sollte. Beispielsweise indizieren die zweiten Informationen für zumindest einen Konfigurationsparameter der Wärmepumpe einen optimierten Wert (z.B. den Wert gemäß der Referenzkonfiguration).

Das Verfahren kann ferner ein Übermitteln der erzeugten Informationen an eine Ausgabeeinrichtung umfassen. Die Ausgabeeinrichtung ist insbesondere dazu eingerichtet, eine Darstellung für einen Benutzer auszugeben, welche dem Benutzer zumindest einen Teil der erzeugten Informationen bereitstellt. Das Verfahren kann das Ausgeben der Darstellung über die Ausgabeeinheit umfassen.

Das Verfahren kann ferner ein Übermitteln der zweiten Informationen an eine Steuervorrichtung der Wärmepumpe umfassen. Die Steuervorrichtung ist insbesondere dazu eingerichtet ist, auf Grundlage der zweiten Informationen den zumindest einen Konfigurationsparameter der Wärmepumpe auf den optimierten Wert einzustellen. Das Verfahren kann das Einstellen des zumindest einen Konfigurationsparameters auf den optimierten Wert umfassen.

Die identifizierte Konfiguration der Wärmepumpe umfasst einen Wert zumindest eines Konfigurationsparameters der Wärmepumpe. Unterschiedliche Konfigurationen der Wärmepumpe, beispielsweise die identifizierte Konfiguration und die Referenzkonfiguration, können sich insbesondere in den jeweiligen Werten des zumindest einen Konfigurationsparameters unterscheiden.

Der zumindest eine Konfigurationsparameter umfasst, insbesondere in Zuordnung zu einer Zeit bzw. Uhrzeit und/oder in Zuordnung zu (z.B. den) Wetterdaten, (a) mindestens eine Schaltzeit der Wärmepumpe, (b) mindestens einen durch die Wärmepumpe bereitzustellenden Temperatur-Sollwert, und/oder (c) mindestens eine Heizkurve der Wärmepumpe. Die mindestens eine Schaltzeit kann eine Zeit eines Einschaltzeitpunkts und/oder eine Zeit eines Ausschaltzeitpunkts der Wärmepumpe umfassen. Der mindestens eine durch die Wärmepumpe bereitzustellende Temperatur-Sollwert kann eine zu erzielende Temperatur des erwärmten Fluids, eine zu erzielende Raumtemperatur und/oder eine zu erzielende Warmwassertemperatur umfassen. Die mindestens eine Heizkurve kann einen zeitlichen Verlauf der zu erzielenden Fluid-, Raum- oder Warmwassertemperatur umfassen. Die mindestens eine Heizkurve kann einen zeitlichen Verlauf einer von einem Sensor der Wärmepumpe ermittelten Betriebstemperatur umfassen. Die mindestens eine Heizkurve kann ein Heizverhalten der Wärmepumpe in einem vordefinierten Zeitintervall, insbesondere 12 Stunden, 24 Stunden, 1 Woche, 1 Monat oder 1 Jahr, festlegen.

Das Verfahren kann ferner, vor dem Identifizieren der Konfiguration der Wärmepumpe, ein Erkennen umfassen, auf Grundlage der Zeitreihe von Messwerten, dass die Betriebsstätte eine Wärmepumpe umfasst. Sofern nicht erkannt wird, dass die Betriebsstätte eine Wärmepumpe umfasst, kann vorgesehen sein, dass die nachfolgenden Verfahrensschritte nicht durchgeführt werden.

Das Verfahren kann ein Erhalten von dritten Informationen umfassen, die indizieren, dass die Betriebsstätte eine Wärmepumpe umfasst. Die dritten Informationen können insbesondere einen Namen, eine Identifikationsnummer, einen Hersteller und/oder eine Angabe einstellbarer Konfigurationsparameter der Wärmepumpe indizieren oder explizit angeben. Sofern keine dritten Informationen erhalten werden, kann vorgesehen sein, dass die nachfolgenden Verfahrensschritte nicht durchgeführt werden.

Gemäß einem zweiten Aspekt wird ein Computerprogrammprodukt bereitgestellt. Das Computerprogrammprodukt umfasst Instruktionen, die, wenn sie durch zumindest eine Recheneinheit ausgeführt werden, die zumindest eine Recheneinheit dazu veranlassen, das Verfahren gemäß dem ersten Aspekt durchzuführen.

Gemäß einem zweiten Aspekt wird System bereitgestellt. Das System umfasst zumindest eine Recheneinheit, die dazu eingerichtet ist, das Verfahren gemäß dem ersten Aspekt durchzuführen.

Das System kann die Messwertbereitstellungseinheit umfassen, die dazu eingerichtet ist, der zumindest einen Recheneinheit die Messwerte des Gesamtstromverbrauchs bereitzustellen. Das System kann die Stromzählervorrichtung umfassen, die dazu eingerichtet ist, zur Generierung der Messwerte den Gesamtstromverbrauch der Betriebsstätte zu messen. Das System kann ferner die Ausgabeeinrichtung umfassen, die dazu eingerichtet ist, eine Darstellung für einen Benutzer auszugeben, welche dem Benutzer zumindest einen Teil der erzeugten Informationen bereitstellt. Das System kann ferner die Steuervorrichtung der Wärmepumpe umfassen, wobei die Steuervorrichtung dazu eingerichtet ist, auf Grundlage der zweiten Informationen den zumindest einen Konfigurationsparameter der Wärmepumpe auf den optimierten Wert einzustellen. Das System kann ferner die Wärmepumpe und/oder den mindestens einen elektrischen Verbraucher umfassen.

Beispielsweise ist die zumindest eine Recheneinheit Teil eines Cloud-basierten Rechensystems oder Teil eines intelligenten Stromzählers (z.B. der Stromzählervorrichtung).

### KURZE BESCHREIBUNG DER ZEICHNUNGEN

Weitere Vorteile, Einzelheiten und Merkmale der hier beschriebenen Vorrichtungen und Systeme ergeben sich aus der nachfolgenden Beschreibung von Ausführungsbeispielen sowie aus den Figuren, wobei dieselben strukturellen und/oder funktionellen Merkmale durchgehend mit denselben Bezugszeichen gekennzeichnet sind.
Fig. 1 zeigt ein System gemäß der vorliegenden Offenbarung; und
Fig. 2 zeigt ein Verfahren gemäß der vorliegenden Offenbarung.

### DETAILLIERTE BESCHREIBUNG

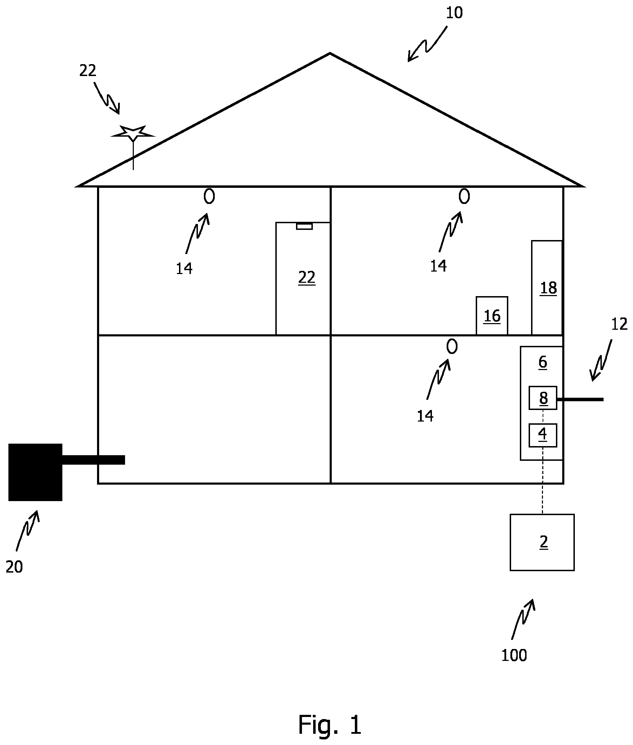

Fig. 1 zeigt ein System 100 gemäß der vorliegenden Offenbarung. In diesem Beispiel umfasst das System eine Recheneinheit 2, die kommunikativ mit einer Messwertbereitstellungseinheit 4 verbunden ist. Die Messwertbereitstellungseinheit 4 ist Teil eines intelligenten Stromzählers (engl. "Smart Meter") 6, welcher auch eine Stromzählervorrichtung 8 umfasst. Das Smart Meter 6 ist in einem Gebäude 10 angeordnet. Die Recheneinheit 2 kann Teil eines Cloud-Rechnernetzwerks, Teil eines externen Servers, oder in das Smart Meter 6 integriert sein. Es ist auch denkbar, die Recheneinheit 2 als Nachrüstkomponente in dem Gebäude 10 an ein Smart Meter 6 zu koppeln.

Ein zentraler Hausanschluss 12 zur Versorgung des Gebäudes mit Strom ist mit dem Smart Meter 6 verbunden. Die Stromzählervorrichtung 6 misst den Gesamtstromverbrauch aller elektrischen Verbraucher, die über den Hausanschluss 12 versorgt werden. In dem Beispiel sind als elektrische Verbraucher Leuchtmittel 14, ein Elektroherd 16 und ein Kühlschrank 18 dargestellt.

Das Gebäude wir über eine Wärmepumpe 20 mit einem erwärmten Fluid versorgt. Auch die Wärmepumpe wird über den zentralen Hausanschluss 12 mit Strom versorgt. Bei den Fluid kann es sich um Warmluft handeln, die in Räume des Gebäudes 10 eingeblasen wird, oder um Warmwasser, welches beispielsweise zum Duschen in der Dusche 22 verwendet werden kann. Die Wärmepumpe 20 weist einstellbare Konfigurationsparameter auf. Insbesondere können Ein- und Ausschaltzeiten der Wärmepumpe, durch die Wärmepumpe bereitzustellende Temperatur-Sollwerte und Heizkurven der Wärmepumpe eingestellt werden.

Alle elektrischen Verbraucher 14-18 sowie die Wärmepumpe 20 werden über dieselbe Hauptzuleitung mit Strom versorgt, der Stromverbrauch aller elektrischen Verbraucher 14-18 sowie der Wärmepumpe wird als Summe bzw. Gesamtstromverbrauch erfasst. Daher kann man sagen, dass die elektrischen Verbraucher 14-18 und die Wärmepumpe 20 Teil derselben Betriebsstätte sind.

Ferner ist eine an dem Gebäude 10 angeordnete Wetterstation 24 dargestellt, welche aktuelle Werte verschiedener Wetterparameter bereitstellt, insbesondere eine aktuelle Außentemperatur. Die Recheneinheit 2 kann mit den von der Wetterstation 24 bereitgestellten Wetterdaten versorgt werden, beispielsweise durch Übermittlung der Daten von der Wetterstation über das Smart Meter 6 an die Recheneinheit 2. Alternativ ist denkbar, dass die Recheneinheit 2 anstelle von Messungen der Wetterstation 24 Wetterdaten erhält, die auf einem Wettermodell basieren.

Das System 100 kann neben der Recheneinheit 2 die Messwertbestimmungseinheit 4, die Stromzählervorrichtung 8, die elektrischen Verbraucher 12-18 und die Wärmepumpe 20 umfassen. Das System 100 kann auch weitere Einheiten bzw. Vorrichtungen umfassen.

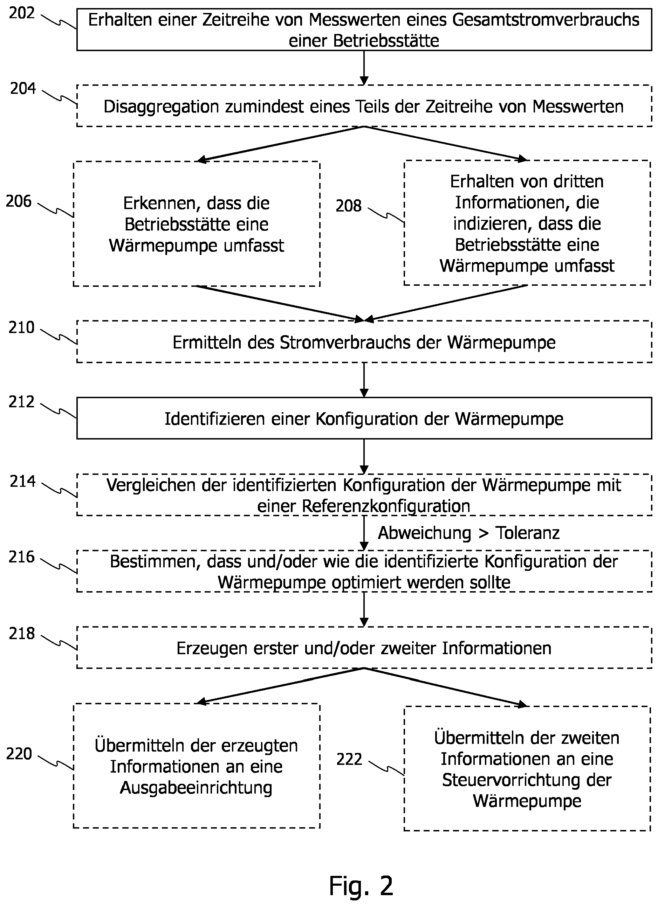

Bezugnehmend auf Fig. 2 wird ein Verfahren beschrieben, welches von der Recheneinheit 2 durchgeführt wird.

Im Schritt 202 wird eine Zeitreihe von Messwerten eines Gesamtstromverbrauchs der Betriebsstätte erhalten. Zumindest einer der Messwerte gibt einen Gesamtstromverbrauch der Betriebsstätte an, der einen Stromverbrauch der Wärmepumpe 20 umfasst. In anderen Worten umfasst die Zeitreihe von Messwerten auch einen Zeitraum, in dem die Wärmepumpe 20 aktiviert bzw. eingeschaltet ist und daher zur Erwärmung des Fluids Strom über den Hausanschluss 12 bezieht. Die Recheneinheit erhält die einzelnen Messwerte von der Messwertbereitstellungseinheit 4. Jeder Messwert ist einem anderen Zeitpunkt der Zeitreihe zugeordnet, die Zeitreihe gibt also einen zeitlichen Verlauf des Gesamtstromverbrauchs des Gebäudes 10 an, in dem Stromverbrauchsanteile aller elektrischen Verbraucher 14-18 und der Wärmepumpe 20 aufsummiert sind.

Im Schritt 204 wird eine Disaggregation zumindest eines Teils der Zeitreihe von Messwerten durchgeführt. Dieser Teil umfasst den zumindest einen Messwert und vorzugsweise auch weitere Messwerte der Zeitreihe. In anderen Worten umfasst dieser Teil der Zeitreihe unter anderem den Zeitraum, in dem die Wärmepumpe 20 aktiviert bzw. eingeschaltet ist, und vorzugsweise auch einen Zeitraum, in dem die Wärmepumpe 20 deaktiviert bzw. ausgeschaltet ist und keine Erwärmung des Fluids unter Bezug von Strom über den Hausanschluss 12 durchführt. Durch die Disaggregation können Stromverbrauchsanteile am Gesamtstromverbrauch den Verbrauchern 14-18 und/oder der Wärmepumpe 20 zugeordnet werden. Hierzu kann eine "Nonintrusive Appliance Load Monitoring", NALM, -Software verwendet werden.

Im Schritt 206 wird auf Grundlage der Zeitreihe von Messwerten, insbesondere im Fall der Detektion eines Stromverbrauchs der Wärmepumpe 20 durch die Disaggregation im Schritt 204, erkannt, dass die Betriebsstätte eine bzw. die Wärmepumpe 20 umfasst. Alternativ oder zusätzlich werden in dem Schritt 208 dritte Informationen erhalten, die indizieren, dass die Betriebsstätte eine bzw. die Wärmepumpe 20 umfasst. Die dritten Informationen können von einem Benutzer oder Wartungspersonal eingegeben werden und insbesondere einen Namen, eine Identifikationsnummer, einen Hersteller und/oder eine Angabe einstellbarer Konfigurationsparameter der Wärmepumpe 20 angeben.

Für den Fall, dass die Betriebsstätte keine Wärmepumpe umfasst oder dass keine dritten Informationen erhalten werden, kann das Verfahren an dieser Stelle abgebrochen werden. Es kann kontinuierlich geprüft werden, ob der Schritt 206 oder 208 möglich ist, und falls dem so ist (z.B. nach dem Einbau der Wärmepumpe 20), kann das Verfahren fortgesetzt werden.

Im Schritt 210 wird der Stromverbrauch der Wärmepumpe für den zumindest einen Messwert bzw. für den Zeitpunkt des zumindest einen Messwerts ermittelt, wobei die Disaggregation aus dem Schritt 204 genutzt werden kann. Die Schritte 204 und 210 können in diesem Fall auch in einem Schritt durchgeführt werden. Der Stromverbrauch der Wärmepumpe 20 wird vorzugsweise für alle Zeitpunkte der Zeitreihe ermittelt.

Im Schritt 212 wird eine Konfiguration der Wärmepumpe 20 identifiziert, und zwar auf Grundlage der Zeitreihe von Messwerten, vorzugsweise auf Grundlage des ermittelten Stromverbrauchs der Wärmepumpe 20. Hierfür kann der Stromverbrauch, insbesondere ein zeitlicher Verlauf des Stromverlaufs, mit einem vorbekannten Stromverbrauch bzw. Stromverbrauchsverlauf verglichen werden, der einer vorbekannten Konfiguration zugeordnet ist. Es kann aus einer Anzahl vorbekannter Konfigurationen eine am besten zu dem ermittelten Stromverbrauch der Wärmepumpe 20 passende Konfiguration ausgewählt und dadurch als Konfiguration der Wärmepumpe 20 identifiziert werden. Für die Auswahl der am besten passenden Konfiguration können auch weitere Kriterien herangezogen werden, beispielsweise eine Wetterhistorie, die für einzelne oder alle Zeitpunkte der Zeitreihe einen Wetterparameter angibt. Es ist auch möglich, dass die Disaggregation nicht nur den Stromverbrauch der Wärmepumpe 20, sondern auch die Konfiguration der Wärmepumpe liefert.

Die identifizierte Konfiguration der Wärmepumpe umfasst zumindest einen Konfigurationsparameter der Wärmepumpe 20. Der Konfigurationsparameter kann einer Uhrzeit und/oder Wetterdaten, insbesondere einer Wetterhistorie, zugeordnet sein. Der zumindest eine Konfigurationsparameter umfasst mindestens eine Schaltzeit der Wärmepumpe 20, mindestens einen durch die Wärmepumpe 20 bereitzustellenden Temperatur-Sollwert (z.B. des zu erwärmenden Fluids) und/oder mindestens eine Heizkurve der Wärmepumpe 20.

Im Schritt 214 wird die identifizierte Konfiguration der Wärmepumpe 20 mit einer Referenzkonfiguration verglichen. Der Vergleich kann einen Vergleich einer Energieeffizienz oder eines Energieverbrauchs gemäß der identifizierten Konfiguration mit einer Energieeffizienz oder einem Energieverbrauch gemäß der Referenzkonfiguration umfassen. Der Vergleich kann einen Vergleich einzelner Werte eines oder mehrerer Konfigurationsparameter zwischen der identifizierten Konfiguration und der Referenzkonfiguration umfassen.

Die Referenzkonfiguration basiert insbesondere auf einem vordefinierten Stromverbrauchsprofil der Wärmepumpe, auf Wetterdaten (z.B. einer Wetterhistorie oder einer Wetterprognose) und/oder einem Verhaltensmuster eines oder mehrerer Bewohner des Gebäudes 10.

Beispielsweise basiert ein Wert zumindest eines Konfigurationsparameters der Referenzkonfiguration auf einer Wetterprognose. In diesem Fall ist die Referenzkonfiguration also an die Wetterprognose angepasst. Dies ist insbesondere dann von Vorteil, wenn zukünftige Umgebungstemperaturänderungen zu erwarten sind. Die Referenzkonfiguration ermöglicht es in diesem Fall, die Wärmepumpe 20 entsprechend zu regeln, bevor die Temperaturänderungen vorliegen. So kann die Effizienz der Wärmepumpe 20 gesteigert werden.

Beispielsweise basiert ein Wert zumindest eines Konfigurationsparameters der Referenzkonfiguration auf dem Verhaltensmuster. Das Verhaltensmuster kann aus dem durch Disaggregation gewonnenen Stromverbrauchsmuster der elektrischen Verbraucher 12-18 ermittelt werden und liefert beispielsweise Informationen über Aufstehzeiten der Bewohner, Duschzeiten der Bewohner, übliche Betriebszeiten der Waschmaschine oder dergleichen. Die Referenzkonfiguration ermöglicht es in diesem Fall, die Regelung der Wärmepumpe 20, also z.B. eine Heizkurve oder einen Einschaltzeitpunkt, auf die Verhaltensmuster abzustimmen, um die Effizienz der Wärmepumpe 20 weiter zu steigern.

Wenn der Vergleich ergibt, dass die identifizierte Konfiguration von der Referenzkonfiguration mehr als eine vordefinierte Toleranz abweicht ("Abweichung > Toleranz"), dann wird Schritt 216 durchgeführt.

Im Schritt 216 wird bestimmt bzw. festgelegt, dass und/oder wie die identifizierte Konfiguration der Wärmepumpe optimiert werden sollte. Beispielsweise wird im Fall einer nicht tolerierten Abweichung eines Werts eines Konfigurationsparameters zwischen der identifizierten Konfiguration und der Referenzkonfiguration bestimmt, dass der Wert des Konfigurationsparameters der Wärmepumpe 20 auf den Wert gemäß der Referenzkonfiguration geändert werden sollte.

Im Schritt 218 werden erst und/oder zweite Informationen erzeugt. Die ersten Informationen indizieren, dass die identifizierte Konfiguration der Wärmepumpe optimiert werden sollte. Die zweiten Informationen indizieren für zumindest einen Konfigurationsparameter der Wärmepumpe einen optimierten Wert (also z.B. den entsprechenden Wert gemäß der Referenzkonfiguration).

Im Schritt 220 werden die erzeugten Informationen an eine Ausgabeeinrichtung übermittelt, die dazu eingerichtet ist, eine Darstellung für einen Benutzer auszugeben, welche dem Benutzer zumindest einen Teil der erzeugten Informationen bereitstellt. Bei der Ausgabeeinrichtung kann es sich um einen Computerbildschirm, ein Mobiltelefon, einen Tablet-Computer oder eine Anzeige des Smart Meters 6 handeln. Dem Benutzer kann signalisiert werden, dass die Wärmepumpe neu eingestellt werden sollte. Dem Benutzer können auch Empfehlungen für Werte einzelner Konfigurationsparameter 20 ausgegeben werden.

Im Schritt 222 werden die zweiten Informationen an eine (in Fig. 1 nicht dargestellte) Steuervorrichtung der Wärmepumpe 20 übermittelt. Diese Steuervorrichtung ist dazu eingerichtet, auf Grundlage der zweiten Informationen den zumindest einen Konfigurationsparameter der Wärmepumpe 20 auf den optimierten Wert (also z.B. den entsprechenden Wert gemäß der Referenzkonfiguration) einzustellen. So kann die Wärmepumpe 20 automatisiert neu eingestellt werden, ohne dass ein Wartungsbetrieb oder ein Bewohner des Gebäudes 10 manuell Änderungen an der Konfiguration der Wärmepumpe 20 vornehmen muss.

Wie in Fig. 2 angedeutet sind die Schritte 204-120 und 214-222 optional. Es ist auch möglich, die Reihenfolge einzelner Verfahrensschritte zu ändern. So könnte der Schritt 208 vor dem Schritt 208 vorgesehen sein, und der Schritt 220 vor dem Schritt 222. Weitere Modifikationen sind ebenso denkbar. Das Verfahren kann auch weitere Schritte umfassen wie z.B. ein Auswählen oder Generieren der Referenzkonfiguration, das Anzeigen der Darstellung für den Benutzer und das Einstellen des zumindest einen Konfigurationsparameters der Wärmepumpe 20. In Hierzu kann das Verfahren von dem System 100 durchgeführt werden, welches neben der Recheneinheit 2 weitere Komponenten wie z.B. die Ausgabeeinrichtung umfassen kann.

Ferner wird ein Computerprogrammprodukt bereitgestellt, welches Instruktionen, umfasst, die, wenn sie durch die Recheneinheit 2 ausgeführt werden, die Recheneinheit 2 dazu veranlassen, das in Bezug auf Fig. 2 beschriebene Verfahren auszuführen.

In den vorgestellten Beispielen sind unterschiedliche Merkmale und Funktionen der vorliegenden Offenbarung getrennt voneinander sowie in bestimmten Kombinationen beschrieben worden. Es versteht sich jedoch, dass viele dieser Merkmale und Funktionen, wo dies nicht explizit ausgeschlossen ist, miteinander frei kombinierbar sind.

## Patentansprüche

1. Verfahren zum Identifizieren einer Konfiguration einer Wärmepumpe, umfassend:
Erhalten (200) einer Zeitreihe von Messwerten eines Gesamtstromverbrauchs einer Betriebsstätte, wobei zumindest einer der Messwerte einen Gesamtstromverbrauch der Betriebsstätte angibt, der einen Stromverbrauch einer Wärmepumpe (20) umfasst; und
Identifizieren (212) einer Konfiguration der Wärmepumpe (20) auf Grundlage der Zeitreihe von Messwerten, wobei
die identifizierte Konfiguration der Wärmepumpe (20)
mindestens eine Schaltzeit der Wärmepumpe (20);
mindestens einen durch die Wärmepumpe (20) bereitzustellenden Temperatur-Sollwert; und/oder
mindestens eine Heizkurve der Wärmepumpe (20)
umfasst.

2. Verfahren nach Anspruch 1, ferner umfassend:
Ermitteln (210) des Stromverbrauchs der Wärmepumpe (20) für den zumindest einen Messwert, wobei die Konfiguration der Wärmepumpe (20) auf Grundlage des ermittelten Stromverbrauchs identifiziert wird.

3. Verfahren nach Anspruch 2, wobei der Stromverbrauch der Wärmepumpe (20) durch Disaggregation (204) zumindest eines Teils der Zeitreihe von Messwerten ermittelt wird, wobei der Teil der Zeitreihe den zumindest einen Messwert umfasst.

4. Verfahren nach Anspruch 3, wobei der Teil der Zeitreihe eine Vielzahl an Messwerten umfasst.

5. Verfahren nach einem der Ansprüche 1 bis 4, ferner umfassend:
Vergleichen (214) der identifizierten Konfiguration der Wärmepumpe (20) mit einer Referenzkonfiguration; und
Bestimmen (216), dass und/oder wie die identifizierte Konfiguration der Wärmepumpe optimiert werden sollte, wenn die identifizierte Konfiguration von der Referenzkonfiguration mehr als eine vordefinierte Toleranz abweicht.

6. Verfahren nach Anspruch 5, wobei die Referenzkonfiguration basiert auf:
einem vordefinierten Stromverbrauchsprofil der Wärmepumpe (20); Wetterdaten; und/oder
einem Verhaltensmuster eines oder mehrerer Bewohner der Betriebsstätte,
wobei ferner optional die Wetterdaten eine Wetterprognose umfassen, und
wobei ferner optional ein Wert zumindest eines Konfigurationsparameters gemäß der Referenzkonfiguration auf der Wetterprognose basiert.

7. Verfahren nach Anspruch 6,
wobei ein Wert zumindest eines Konfigurationsparameters gemäß der Referenzkonfiguration auf dem Verhaltensmuster basiert,
wobei ferner optional das Verhaltensmuster auf einem jeweiligen Stromverbrauch der Wärmepumpe (20) und mindestens eines elektrischen Verbrauchers (14; 16; 18) der Betriebsstätte basiert, und
wobei ferner optional der jeweilige Stromverbrauch durch Disaggregation zumindest eines Teils der Zeitreihe von Messwerten ermittelt ist.

8. Verfahren nach einem der Ansprüche 5 bis 7, ferner umfassend:
Erzeugen (218) erster Informationen, wenn bestimmt wird, dass die identifizierte Konfiguration der Wärmepumpe (20) optimiert werden sollte, wobei die ersten Informationen indizieren, dass die identifizierte Konfiguration der Wärmepumpe (20) optimiert werden sollte; und/oder
Erzeugen (218) zweiter Informationen, wenn bestimmt wird, wie die identifizierte Konfiguration der Wärmepumpe (20) optimiert werden sollte, wobei die zweiten Informationen für zumindest einen Konfigurationsparameter der Wärmepumpe (20) einen optimierten Wert indizieren,
wobei das Verfahren ferner optional umfasst:
Übermitteln (220) der erzeugten Informationen an eine Ausgabeeinrichtung, die dazu eingerichtet ist, eine Darstellung für einen Benutzer auszugeben, welche dem Benutzer zumindest einen Teil der erzeugten Informationen bereitstellt.

9. Verfahren nach Anspruch 8, ferner umfassend:
Übermitteln (222) der zweiten Informationen an eine Steuervorrichtung der Wärmepumpe (20), wobei die Steuervorrichtung dazu eingerichtet ist, auf Grundlage der zweiten Informationen den zumindest einen Konfigurationsparameter der Wärmepumpe (20) auf den optimierten Wert einzustellen.

10. Verfahren nach einem der Ansprüche 1 bis 9, ferner umfassend, vor dem Identifizieren (212) der Konfiguration der Wärmepumpe:
Erkennen (206), auf Grundlage der Zeitreihe von Messwerten, dass die Betriebsstätte eine Wärmepumpe (20) umfasst; und/oder
Erhalten (208) von dritten Informationen, die indizieren, dass die Betriebsstätte eine Wärmepumpe (20) umfasst, wobei die dritten Informationen insbesondere einen Namen, eine Identifikationsnummer, einen Hersteller und/oder eine Angabe einstellbarer Konfigurationsparameter der Wärmepumpe (20) indizieren.

11. Computerprogrammprodukt, umfassend Instruktionen, die, wenn sie durch zumindest eine Recheneinheit (2) ausgeführt werden, die zumindest Recheneinheit (2) dazu veranlassen, das Verfahren gemäß einem der Ansprüche 1 bis 10 durchzuführen.

12. System (100), umfassend:
zumindest eine Recheneinheit (2), die dazu eingerichtet ist, das Verfahren gemäß einem der Ansprüche 1 bis 10 durchzuführen.

13. System (100) nach Anspruch 12, ferner umfassend:
eine Messwertbereitstellungseinheit (4), die dazu eingerichtet ist, der zumindest einen Recheneinheit (2) die Messwerte des Gesamtstromverbrauchs bereitzustellen,
wobei das System (100) ferner optional umfasst:
eine Stromzählervorrichtung (8), die dazu eingerichtet ist, zur Generierung der Messwerte den Gesamtstromverbrauch der Betriebsstätte zu messen,
wobei ferner optional die zumindest eine Recheneinheit (2) Teil eines Cloud-basierten Rechensystems oder Teil eines intelligenten Stromzählers (6) ist.

## Claims

1. Method for identifying a configuration of a heat pump, comprising:
receiving (200) a time series of measured values of a total power consumption of an operating site, wherein at least one of the measured values indicates a total power consumption of the operating site that comprises a power consumption of a heat pump (20); and
identifying (212) a configuration of the heat pump (20) on the basis of the time series of measured values, wherein
the identified configuration of the heat pump (20) comprises
at least one switching time of the heat pump (20);
at least one temperature setpoint to be provided by the heat pump (20); and/or at least one heating curve of the heat pump (20).

2. Method according to claim 1, further comprising:
determining (210) the power consumption of the heat pump (20) for the at least one measured value, wherein the configuration of the heat pump (20) is identified on the basis of the determined power consumption.

3. Method according to claim 2, wherein the power consumption of the heat pump (20) is determined by disaggregation (204) of at least a part of the time series of measured values, wherein the part of the time series comprises the at least one measured value.

4. Method according to claim 3, wherein the part of the time series comprises a plurality of measured values.

5. Method according to one of claims 1 to 4, further comprising:
comparing (214) the identified configuration of the heat pump (20) with a reference configuration; and
determining (216) that and/or how the identified configuration of the heat pump should be optimized, if the identified configuration deviates from the reference configuration by more than a predefined tolerance.

6. Method according to claim 5, wherein the reference configuration is based on:
a predefined power consumption profile of the heat pump (20);
weather data; and/or
a behavior pattern of one or more residents of the operating site,
wherein further optionally the weather data comprise a weather forecast, and
wherein further optionally a value of at least one configuration parameter in accordance with the reference configuration is based on the weather forecast.

7. Method according to claim 6,
wherein a value of at least one configuration parameter in accordance with the reference configuration is based on the behavior pattern,
wherein further optionally the behavior pattern is based on a respective power consumption of the heat pump (20) and at least one electrical load (14; 16; 18) of the operating site, and
wherein further optionally the respective power consumption is determined by disaggregation of at least a part of the time series of measured values.

8. Method according to one of claims 5 to 7, further comprising:
generating (218) first information, if it is determined that the identified configuration of the heat pump (20) should be optimized, wherein the first information indicates that the identified configuration of the heat pump (20) should be optimized; and/or
generating (218) second information, if it is determined how the identified configuration of the heat pump (20) should be optimized, wherein the second information indicates an optimized value for at least one configuration parameter of the heat pump (20),
wherein the method further optionally comprises:
transmitting (220) the generated information to an output device that is configured to output a presentation for a user, which provides the user with at least a part of the generated information.

9. Method according to claim 8, further comprising:
transmitting (222) the second information to a control device of the heat pump (20), wherein the control device is configured to set the at least one configuration parameter of the heat pump (20) to the optimized value on the basis of the second information.

10. Method according to one of claims 1 to 9, further comprising, before identifying (212) the configuration of the heat pump:
detecting (206), on the basis of the time series of measured values, that the operating site comprises a heat pump (20); and/or
receiving (208) third information that indicates that the operating site comprises a heat pump (20), wherein the third information indicates in particular a name, an identification number, a manufacturer and/or an indication of adjustable configuration parameters of the heat pump (20).

11. Computer program product, comprising instructions that, when executed by at least one computing unit (2), cause the at least one computing unit (2) to carry out the method according to one of claims 1 to 10.

12. System (100), comprising:
at least one computing unit (2) that is configured to carry out the method according to one of claims 1 to 10.

13. System (100) according to claim 12, further comprising:
a measured-value provision unit (4) that is configured to provide the measured values of the total power consumption to the at least one computing unit (2),
wherein the system (100) further optionally comprises:
a power meter device (8) that is configured to measure the total power consumption of the operating site in order to generate the measured values,
wherein further optionally the at least one computing unit (2) is part of a cloud-based computing system or part of a smart meter (6).

## Revendications

1. Procédé d'identification d'une configuration d'une pompe à chaleur, comprenant:
l'obtention (200) une série chronologique de valeurs mesurées d'une consommation électrique totale d'un établissement, au moins l'une des valeurs mesurées indiquant une consommation électrique totale du site d'exploitation qui comprend une consommation électrique d'une pompe à chaleur (20); et
l'identification (212) d'une configuration de la pompe à chaleur (20) sur la base de la série chronologique de valeurs mesurées, dans lequel
la configuration identifiée de la pompe à chaleur (20) comprend au moins un temps de commutation de la pompe à chaleur (20);
au moins une valeur de consigne de température à fournir par la pompe à chaleur (20); et/ou
au moins une courbe de chauffage de la pompe à chaleur (20).

2. Procédé selon la revendication 1, comprenant en outre:
la détermination (210) de la consommation électrique de la pompe à chaleur (20) pour l'au moins une valeur mesurée, la configuration de la pompe à chaleur (20) étant identifiée sur la base de la consommation électrique déterminée.

3. Procédé selon la revendication 2, dans lequel la consommation électrique de la pompe à chaleur (20) est déterminée par désagrégation (204) d'au moins une partie de la série chronologique de valeurs mesurées, ladite partie de la série chronologique comprenant au moins une valeur mesurée.

4. Procédé selon la revendication 3, dans lequel la partie de la série chronologique comprend une pluralité de valeurs mesurées.

5. Procédé selon l'une quelconque des revendication 1 à 4, comprenant en outre:
la comparaison (214) de la configuration identifiée de la pompe à chaleur (20) à une configuration de référence; et
le fait de déterminer (216) que et/ou comment la configuration identifiée de la pompe à chaleur doit être optimisée lorsque la configuration identifiée s'écarte de la configuration de référence de plus d'une tolérance prédéfinie.

6. Procédé selon la revendication 5, dans lequel la configuration de référence se base sur:
un profil de consommation électrique prédéfini de la pompe à chaleur (20);
des données météorologiques; et/ou
un modèle de comportement d'un ou plusieurs occupants de l'établissement,
dans lequel les données météorologiques peuvent, éventuellement, aussi comprendre des prévisions météorologiques, et
dans lequel une valeur d'au moins un paramètre de configuration selon la configuration de référence est en outre basée, éventuellement, sur les prévisions météorologiques.

7. Procédé selon la revendication 6,
dans lequel une valeur d'au moins un paramètre de configuration est basée sur le modèle de comportement conformément à la configuration de référence,
dans lequel le modèle de comportement est en outre basé, éventuellement, sur la consommation électrique respective de la pompe à chaleur (20) et d'au moins un consommateur électrique (14; 16; 18) de l'établissement, et
dans lequel la consommation électrique respective étant en outre déterminée éventuellement par désagrégation d'au moins une partie de la série chronologique de valeurs mesurées.

8. Procédé selon l'une quelconque des revendication 5 à 7, comprenant en outre:
la génération (218) de premières informations lorsqu'il est déterminé que la configuration identifiée de la pompe à chaleur (20) doit être optimisée, les premières informations indiquant que la configuration identifiée de la pompe à chaleur (20) doit être optimisée; et/ou
la génération (218) de deuxièmes informations lorsqu'il est déterminé comment la configuration identifiée de la pompe à chaleur (20) doit être optimisée, les deuxièmes informations indiquant une valeur optimisée pour au moins un paramètre de configuration de la pompe à chaleur (20),
le procédé comprenant éventuellement en outre:
la transmission (220) des informations générées à un dispositif de sortie qui est configuré pour fournir à un utilisateur une représentation qui met à la disposition de l'utilisateur au moins une partie des informations générées.

9. Procédé selon la revendication 8, comprenant en outre:
la transmission (222) de deuxièmes informations à un dispositif de commande de la pompe à chaleur (20), le dispositif de commande étant conçu pour régler, sur la base des deuxièmes informations, l'au moins un paramètre de configuration de la pompe à chaleur (20) à la valeur optimisée.

10. Procédé selon l'une quelconque des revendications 1 à 9, comprenant en outre, avant l'identification (212) de la configuration de la pompe à chaleur:
la reconnaissance (206), sur la base de la série chronologique de valeurs mesurées, que l'établissement est équipé d'une pompe à chaleur (20); et/ou
l'obtention (208) de troisièmes informations indiquant que l'établissement est équipé d'une pompe à chaleur (20), les troisièmes informations indiquant en particulier un nom, un numéro d'identification, un fabricant et/ou une indication concernant les paramètres de configuration réglables de la pompe à chaleur (20).

11. Produit programme informatique, comprenant des instructions qui, lorsqu'elles sont exécutées par au moins un processeur (2) amènent le processeur (2) à mettre en œuvre le procédé selon l'une quelconque des revendications 1 à 10.

12. Système (100), comprenant:
au moins un processeur (2) qui est configuré pour mettre en œuvre le procédé selon l'une quelconque des revendications 1 à 10.

13. Système (100) selon la revendication 12, comprenant en outre:
une unité de fourniture de valeurs mesurées (4) qui est conçue pour fournir à l'au moins un processeur (2) les valeurs mesurées de la consommation électrique totale,
le système (100) comprenant éventuellement en outre:
un compteur électrique (8) qui est conçu pour mesurer la consommation électrique totale de l'établissement afin de générer les valeurs mesurées,
dans lequel, en outre, éventuellement, l'au moins un processeur (2) fait partie d'un système informatique en nuage ou fait partie d'un compteur électrique intelligent (6).
